# EUROPÄISCHE PATENTANMELDUNG

(11) **EP 4 635 778 A1**
(43) Veröffentlichungstag der Anmeldung: **22.10.2025**
(21) Anmeldenummer: 25170714.7
(22) Anmeldetag: 15.04.2025
(51) Int. Cl.: B60L 3/00, B60L 53/16, G01R 1/04, G01R 31/00, H01R 31/06

(54) **MESSADAPTER FÜR EINE LADEBUCHSE EINES ELEKTROFAHRZEUGS**

(30) Priorität: 16.04.2024 AT 503182024
(71) Anmelder: AVL DiTest GmbH, 8020 Graz (AT)
(72) Erfinder: Schwaiger, Patrik, 8542 Deutschlandsberg (AT); Huber, Christian, 8045 Graz (AT); Schulz, Jonas, 8041 Graz (AT)
(74) Vertreter: Patentanwälte Pinter & Weiss OG

(57) **Zusammenfassung**

Für einen einfach handzuhabenden und flexible einsetzbaren Messadapter (1) für eine Ladebuchse eines Elektrofahrzeugs zu realisieren ist der Messadapter (1) mit zwei Ladesteckern ausgeführt, wobei ein zweiter Ladestecker (5) am Messadapter (1) relativ zum ersten Ladestecker (4) bewegbar angeordnet ist und der zweite Ladestecker (5) zwischen einer Messposition (M) und einer Passivposition (P) hin und her bewegbar angeordnet ist, wobei der erste Ladestecker (4) eine Mehrzahl von ersten Ladesteckerkontakten (6) aufweist, und der zweite Ladestecker (5) eine Mehrzahl von zweiten Ladesteckerkontakten (7) aufweist, und wobei jeder der ersten Ladesteckerkontakte (6) und jeder der zweiten Ladesteckerkontakte (7) jeweils mit einem Messkontakt (10) des Messadapters (1) verbunden ist.

## Beschreibung

Die gegenständliche Erfindung betrifft einen Messadapter für eine Ladebuchse eines Elektrofahrzeugs.

Elektrofahrzeuge, worunter im Rahmen dieser Anmeldung sowohl reine Elektrofahrzeuge als auch Hybridfahrzeuge verstanden werden, stellen eine zusätzliche Herausforderung für Werkstätten dar. Für Elektrofahrzeuge sind im Rahmen der regelmäßigen Fahrzeugüberprüfung eine Reihe von Messungen am elektrischen System des Elektrofahrzeugs notwendig, beispielsweise eine Messung des Isolationswiderstandes zwischen dem elektrischen Bordnetz des Elektrofahrzeugs und dem Chassis oder Messungen an der Ladebuchse des Elektrofahrzeugs. Aufgrund des üblicherweise vorgesehenen Hochvolt-Bordnetzes mit Gleichstrom (DC) Spannungen im Bereich mehrerer hundert Volt, stellt das ein hohes Sicherheitsrisiko für Personen dar, die solche Messungen ausführen. Um Messungen an einer Ladebuchse eines Elektrofahrzeugs zu machen sind daher Adapter im Einsatz, die an die Ladebuchse angesteckt werden und die dann über sichere Messzugänge die notwendigen Messungen erlauben. Es gibt allerdings eine Reihe von verschiedenen Ladebuchsen an Elektrofahrzeugen. In Europa gängig sind beispielsweise eine Typ-2 Ladebuchse nach EN 62196 für das Laden mit einer Wechselstrom (AC) Spannung oder eine Combined Charging System (CCS) Ladebuchse nach EN 62196 für das Laden mit einer AC-Spannung (mit einer Typ-2 Buchse) oder DC-Spannung. Es gibt aber auch noch Typ-1 Ladebuchsen für das Laden mit einer AC-Spannung, wobei die Ladebuchse nur für eine einphasige Wechselspannung ausgeführt ist. Damit werden in einer Werkstätte verschiedenste Adapter für Ladebuchsen benötigt, um an allen Ladebuchsen die benötigten Messungen durchführen zu können. Heute verfügbare CCS-Adapter haben zudem oftmals die Kontakte für den Typ-2 Buchse nicht ausgeführt und ermöglichen daher keine Messungen an der Typ-2 Buchse der CCS-Ladebuchse, womit ein eigener Typ-2 Adapter benötigt wird. Für den Werkstättenbetrieb ist das aber äußert umständlich und unbefriedigend.

Es besteht damit Bedarf nach einem Messadapter, der Messungen an Ladebuchsen von Elektrofahrzeugen, insbesondere im Umfeld einer Werkstätte, vereinfacht.

Diese Aufgabe wird mit einem eingangs genannten Messadapter gelöst, wobei der Messadapter einen ersten Ladestecker mit einem ersten Ladesteckertyp und einen zweiten Ladestecker mit einem zweiten Ladesteckertyp aufweist und bei dem der zweite Ladestecker am Messadapter relativ zum ersten Ladestecker bewegbar angeordnet ist und der zweite Ladestecker zwischen einer Messposition und einer Passivposition hin und her bewegbar angeordnet ist, wobei der erste Ladestecker eine Mehrzahl von ersten Ladesteckerkontakten aufweist, und der zweite Ladestecker eine Mehrzahl von zweiten Ladesteckerkontakten aufweist, und jeder der ersten Ladesteckerkontakte und jeder der zweiten Ladesteckerkontakte jeweils mit einem Messkontakt des Messadapters verbunden ist. Vorteilhaft ist der zweite Ladesteckertyp unterschiedlich zum ersten Ladesteckertyp. Damit kann ein einziger Messadapter für verschiedene Ladebuchsen von Elektrofahrzeugen verwendet werden, was insbesondere den Werkstätteneinsatz des Messadapters vereinfacht. Mit dem erfindungsgemäßen Messadapter ist an oder mit jedem Ladesteckerkontakt, eine Messung über den Messadapter und die Messkontakte möglich.

In einer möglichen Ausführung sind die Messkontakte des Messadapters können über zugehörige Messleitungen eines Messkabels mit einem Messgerät verbunden. In einer anderen möglichen Ausführung kann der Messadapter einen Messblock mit Messbuchsen umfassen und jeder Messkontakt des Messadapters über zugehörige Messleitungen eines Messkabels mit einer der Messbuchsen verbunden sein. In einer weiteren Ausführung ist am Messadapter ein Messblock mit Messbuchsen vorgesehen und jeder Messkontakt des Messadapters mit einer der Messbuchsen verbunden ist.

Wenn zwischen zumindest einem Ladesteckerkontakt und dem zugehörigen Messkontakt eine Sicherung vorgesehen ist, dann kann der Messadapter auch bei aktiven HV-Bordnetz eines Elektrofahrzeugs eingesetzt werden, weil die Sicherung gegen Überspannung schützt.

Die gegenständliche Erfindung wird nachfolgend unter Bezugnahme auf die Figuren 1 bis 3 näher erläutert, die beispielhaft, schematisch und nicht einschränkend vorteilhafte Ausgestaltungen der Erfindung zeigen. Dabei zeigt
Fig.1 eine Ausgestaltung eines erfindungsgemäßen Messadapters,
Fig.2 eine weitere Ausgestaltung eines erfindungsgemäßen Messadapters und
Fig.3 noch eine weiter Ausgestaltung eines erfindungsgemäßen Messadapters.

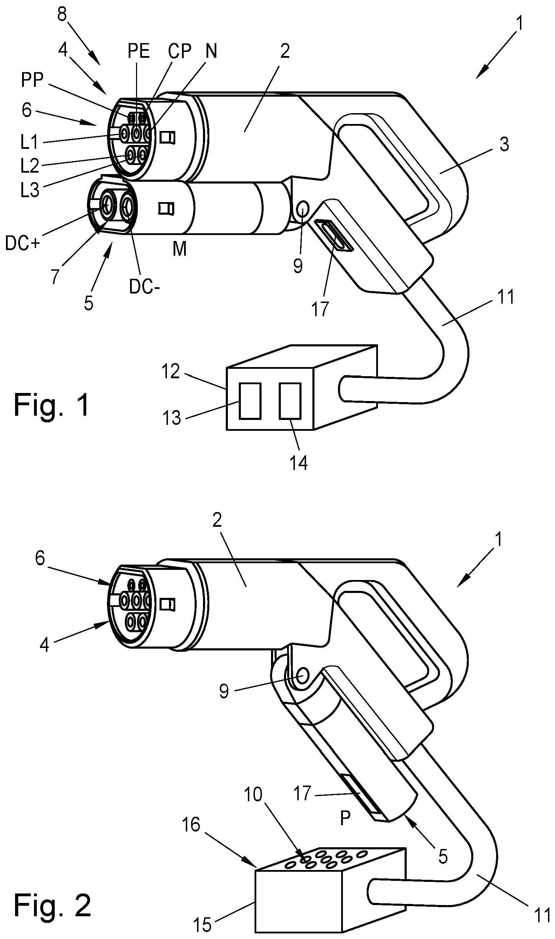

Fig.1 zeigt einen erfindungsgemäßen Messadapter 1 für eine Ladebuchse an einem Elektrofahrzeug (beides nicht dargestellt, weil hinlänglich bekannt). Der Messadapter 1 umfasst einen Adapterkörper 2, an dem auch ein Griff 3 vorgesehen sein kann, wie in der Ausführung nach Fig.1. Der Messadapter 1 umfasst zwei Ladestecker 4, 5.

Ein erster Ladestecker 4 ist gemäß eines ersten Ladesteckertyps ausgeführt. In der Ausführung nach Fig.1 ist der erste Ladesteckertyp ein Typ-2 Ladestecker nach EN 62196, insbesondere ein Ladestecker vorgesehen für das Laden mit einer AC-Spannung. Der erste Ladesteckertyp könnte aber auch ein Typ-1 Ladestecker sein, oder auch ein andere Ladesteckertyp. Der erste Ladestecker 4 hat eine Mehrzahl von ersten Ladesteckerkontakten 6. Bei Verwendung des Messadapters 1 kann der erste Ladestecker 4 in eine passende Ladebuchse des Elektrofahrzeugs gesteckt werden, um Buchsenkontakte der Ladebuchse zu kontaktieren. Die Ladebuchse ist beispielsweise eine Typ-2 oder Typ-1 Ladebuchse.

Im Falle eines Typ-2 Ladesteckers 4 umfassen die ersten Ladesteckerkontakte 6 in bekannter und standardisierter Weise drei AC Ladespannungskontakte L1, L2, L3, einen Nullleiterkontakt N, einen Erdkontakt PE und zwei Steuerkontakte PP, CP.

Ein zweiter Ladestecker 5 ist gemäß eines zweiten Ladesteckertyps ausgeführt. Der zweite Ladesteckertyp ist unterschiedlich vom ersten Ladesteckertyp.

In der Ausführung nach Fig.1 ist der zweite Ladestecker 5 als CCS-Ladestecker ausgeführt, wie ein Ladestecker vorgesehen für das Laden mit einer DC-Spannung. Gemeinsam mit dem ersten Ladestecker 4 kann auch ein CCS Combi Ladestecker realisiert werden, wie ein Ladestecker vorgesehen für das Laden mit einer AC- oder DC-Spannung. Der zweite Ladesteckertyp könnte aber auch ein anderer Ladesteckertyp sein. Der zweite Ladestecker 5 hat eine Mehrzahl von zweiten Ladesteckerkontakten 7. Bei Verwendung des Messadapters 1 nach Fig.1 wird der zweite Ladestecker 5 alleine oder gemeinsame mit dem ersten Ladestecker 4 in eine passende Ladebuchse des Elektroautos gesteckt, um Buchsenkontakte der Ladebuchse zu kontaktieren. Die Ladebuchse ist beispielsweise eine CCS oder CCS Combi Ladebuchse.

Im Falle eines CCS-Ladesteckers 8 umfassen die zweiten Ladesteckerkontakte 7 in bekannter und standardisierter Weise zwei DC Ladespannungskontakte DC+, DC-. Im Falle einer Ladung mit einer DC-Spannung, kann der CCS-Ladestecker 8 die Steuerkontakte PP, CP und auch den Erdkontakt PE des ersten Ladesteckers 4 nutzen, der dann ebenso in die zugehörige Ladebuchse zu stecken wäre. In einer anderen möglichen Ausführung können aber alle notwendigen Kontakte auch am zweiten Ladestecker 5 realisiert sein.

Die Ladesteckertypen und die Ladesteckerkontakte 6, 7 sind für die Erfindung unerheblich, sondern sind von der am Elektrofahrzeug vorgesehen Ladebuchse abhängig. Beispielsweise könnte in USA oder Asien oder für ein bestimmtes Elektrofahrzeug ein anderer Ladesteckertyp vorgesehen sein, wie ein TESLA Supercharger Ladestecker oder ein CHAdeMo Ladestecker.

Die Ladesteckerkontakte 6, 7 am Messadapter 1 sind in der Regel weiblich ausgeführt.

Der erfindungsgemäße Messadapter 1 zeichnet sich dadurch aus, dass der zweite Ladestecker 5 am Messadapter 1 relativ zum ersten Ladestecker 4 bewegbar angeordnet ist und der zweite Ladestecker 5 zwischen einer Messposition M (Fig.1) und einer Passivposition P (Fig.2) hin und her bewegbar angeordnet ist.

In der Messposition M kann der zweite Ladestecker 5 zur Messung in eine Ladebuchse des Elektrofahrzeugs gesteckt werden. Vorzugsweise werden in der Messposition M des zweiten Ladesteckers 5 der erste Ladestecker 4 und der zweite Ladestecker 5 gleichzeitig in jeweils ein zugehörige Ladebuchse des Elektrofahrzeugs gesteckt. Damit können mit einem Messadapter 1 Messungen an verschiedenen Elektrofahrzeugen vorgenommen werden. Insbesondere kann nur der erste Ladestecker 4 in eine zugehörige Ladebuchse des Elektrofahrzeugs gesteckt werden, oder nur der zweite Ladestecker 5, oder es können beide gleichzeitig in jeweils zugehörige Ladebuchsen des Elektrofahrzeugs gesteckt werden.

Wenn der Messadapter 1 für eine CCS-Ladebuchse vorgesehen ist, dann kann der erste Ladestecker 4 ein Typ-1 oder Typ-2 Ladestecker sein, der alleine in eine Typ-1 oder Typ-2 Ladebuchse gesteckt werden kann. Hierzu wäre der zweite Ladestecker 5 in der Passivposition (Fig.2). Ist der zweite Ladestecker 5 in der Messposition (Fig.1), dann könnte der Messadapter 1 einen CCS Combi Ladestecker ausbilden und der erste Ladestecker 4 und der zweite Ladestecker 5 würden gemeinsam in eine CCS Combi Ladebuchse des Elektrofahrzeugs gesteckt.

In der Ausführung nach Fig.1 und Fig.2 ist der zweite Ladestecker 5 am Messadapter 1 um eine Drehachse 9 verschwenkbar angeordnet. Der zweite Ladestecker 5 könnte aber auch relativ zum ersten Ladestecker 4 verschiebbar am Messadapter 1 angeordnet sein. Auch eine kombinierte translatorische und rotatorische Bewegung des zweiten Ladesteckers 5 relativ zum ersten Ladestecker 4 wäre möglich, um den zweite Ladestecker 5 zwischen der Messposition M und der Passivposition P zu bewegen.

Der erfindungsgemäße Messadapter 1 ist zudem dadurch ausgezeichnet, dass jeder der ersten Ladesteckerkontakte 6 und jeder der zweiten Ladesteckerkontakte 7 jeweils mit einem Messkontakt 10 des Messadapters 1 verbunden ist.

Die Messkontakte 10 des Messadapters 1 könnten beispielsweise über einzelne Messleitungen eines Messkabels 11 zu einem Messgerät 12 geführt sein. Mit dem Messgerät 12 könnten dann Messungen an der Ladebuchse des Elektrofahrzeugs durchgeführt werden, wenn der Messadapter 1 in die Ladebuchse gesteckt ist. In diesem Fall müssen die Messkontakte 10 nicht eigens nach außen geführt sein, um von extern kontaktiert zu werden. Beispielsweise könnte eine Spannungsmessung zwischen verschiedenen Ladesteckerkontakten 6, 7 oder eine Isolationswiderstandsmessung zwischen einem Ladesteckerkontakte 6, 7 und Erde durchgeführt werden. Hierzu könnte am Messgerät 12 auch eine Ausgabeeinheit 13, wie eine Anzeige, Leuchten usw., und eine Eingabeeinheit 14, wie ein Touchpad, eine Tastatur, Knöpfe, Schieber, Regler usw., vorgesehen sein.

Alternativ könnten die Messkontakte 10 des Messadapters 1 auch über einzelne Leitungen eines Messkabels 11 zu einem Messblock 15 geführt sein, wie in Fig.2. Am Messblock 15 sind Messbuchsen 16 (entsprechend der Mehrzahl der Ladesteckerkontakte 6, 7) vorgesehen. Die Messbuchsen 16, beispielsweise 4mm-Laborbuchsen, können mit einem externen Messgerät, beispielweise einem Multimeter mit Messspitzen, kontaktiert werden, um die benötigten Messungen vorzunehmen. In diesem Fall sind die Messkontakte 10 somit von extern kontaktierbar. Solche Messbuchsen 16 könnten zusätzlich auch an einem Messgerät 12 der Fig.1 vorgesehen sein.

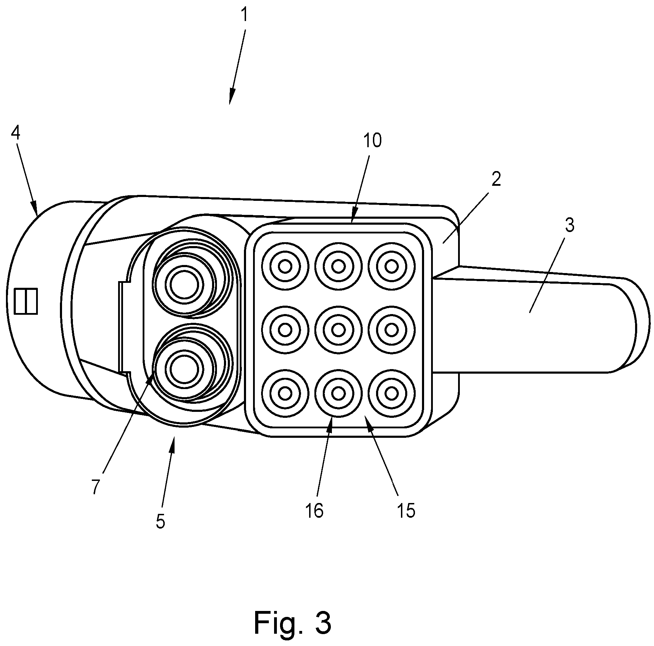

In einer weiteren alternativen Ausführung, wie in Fig.3 dargestellt, könnte ein solcher Messblock 15, oder auch nur Messbuchsen 16 alleine, auch am Messadapter 1 selbst ausgeführt sein. In diesem Fall könnte ein Messkabel 11 auch entfallen. Denkbar wäre aber auch, zusätzlich ein Messkabel 11 vorzusehen, um den Messadapter 1 wahlweise auch mit einem Messgerät 12 verbinden zu können.

Im Messadapter 1 kann zwischen zumindest einem Ladesteckerkontakt 6, 7 und dem zugehörigen Messkontakt 10 eine Sicherung vorgesehen sein, um gegen elektrische Überströme zu schützen. Damit könnte der Messadapter 1 auch bei aktivem und an die Ladebuchse geschalteten Hochvolt-Bordnetz des Elektrofahrzeugs 1 verwendet werden.

Weiters kann am Messadapter 1 auch eine Fixiereinheit vorgesehen sein, um den zweiten Ladestecker 5 in der Messposition M und/oder der Passivposition P zu fixieren. Die Fixiereinheit kann beispielsweise mittels geeignet angeordneten Magneten 17 am Adapterkörper 2 und am zweiten Ladestecker 5 ausgeführt sein.

## Patentansprüche

1. Messadapter für eine Ladebuchse eines Elektrofahrzeugs, **dadurch gekennzeichnet, dass** der Messadapter (1) einen ersten Ladestecker (4) mit einem ersten Ladesteckertyp und einen zweiten Ladestecker (5) mit einem zweiten Ladesteckertyp aufweist, **dass** der zweite Ladestecker (5) am Messadapter (1) relativ zum ersten Ladestecker (4) bewegbar angeordnet ist und der zweite Ladestecker (5) zwischen einer Messposition (M) und einer Passivposition (P) hin und her bewegbar angeordnet ist, **dass** der erste Ladestecker (4) eine Mehrzahl von ersten Ladesteckerkontakten (6) aufweist, und der zweite Ladestecker (5) eine Mehrzahl von zweiten Ladesteckerkontakten (7) aufweist, **und dass** jeder der ersten Ladesteckerkontakte (6) und jeder der zweiten Ladesteckerkontakte (7) jeweils mit einem Messkontakt (10) des Messadapters (1) verbunden ist.

2. Messadapter nach Anspruch 1, **dadurch gekennzeichnet, dass** der zweite Ladestecker (5) um eine Drehachse (9) verschwenkbar am Messadapter (1) angeordnet ist.

3. Messadapter nach Anspruch 1 oder 2, **dadurch gekennzeichnet, dass** die Messkontakte (10) des Messadapters (1) über zugehörige Messleitungen eines Messkabels (11) mit einem Messgerät (12) verbunden sind.

4. Messadapter nach Anspruch 1 oder 2, **dadurch gekennzeichnet, dass** der Messadapter (1) einen Messblock (15) mit Messbuchsen (16) umfasst und jeder Messkontakt (10) des Messadapters (1) über zugehörige Messleitungen eines Messkabels (11) mit einer der Messbuchsen (16) verbunden ist.

5. Messadapter nach Anspruch 1 oder 2, **dadurch gekennzeichnet, dass** am Messadapter (1) ein Messblock (15) mit Messbuchsen (16) vorgesehen ist und jeder Messkontakt (10) des Messadapters (1) mit einer der Messbuchsen (16) verbunden ist.

6. Messadapter nach einem der Ansprüche 1 bis 5, **dadurch gekennzeichnet, dass** zwischen zumindest einem der ersten und zweiten Ladesteckerkontakte (6, 7) und dem zugehörigen Messkontakt (10) eine Sicherung vorgesehen ist.

7. Messadapter nach einem der Ansprüche 1 bis 6, **dadurch gekennzeichnet, dass** am Messadapter (1) eine Fixiereinheit (17) vorgesehen ist, um den zweiten Ladestecker (5) in der Messposition (M) und/oder in der Passivposition (P) lösbar zu fixieren.
